Europäisches Patentamt

European Patent Office

Office européen des brevets

(19)

(11) **EP 1 198 719 B1**

(12) **EUROPEAN PATENT SPECIFICATION**

(45) Date of publication and mention
of the grant of the patent:
**01.12.2004 Bulletin 2004/49**

(21) Application number: **99932082.3**

(22) Date of filing: **29.06.1999**

(51) Int Cl.⁷: $G01R\ 33/02$

(86) International application number:
**PCT/US1999/014781**

(87) International publication number:
**WO 2001/001163 (04.01.2001 Gazette 2001/01)**

(54) **METHOD AND APPARATUS FOR SENSING A MAGNETIC FIELD USING A LORENTZ FORCE AND A PIEZOELECTRIC EFFECT**

VERFAHREN UND VORRICHTUNG ZUM MESSEN EINES MAGNETFELDES MITTELS LORENTZKRAFT UND PIEZOELEKTRISCHES EFFEKTS

PROCEDE ET APPAREIL POUR DETECTER UN CHAMP MAGNETIQUE PAR LA FORCE DE LORENTZ ET UN EFFET PIEZOELECTRIQUE

(84) Designated Contracting States:
**AT BE CH CY DE DK ES FI FR GB GR IE IT LI LU MC NL PT SE**

(43) Date of publication of application:
**24.04.2002 Bulletin 2002/17**

(73) Proprietor: **Honeywell Inc.**
**Morristown, New Jersey 07962 (US)**

(72) Inventor: **CHEN, Bo, Su**
**Freeport, IL 61032 (US)**

(74) Representative: **Hucker, Charlotte Jane et al**
**Gill Jennings & Every**
**Broadgate House,**
**7 Eldon Street**
**London EC2M 7LH (GB)**

(56) References cited:
**GB-A- 1 279 091      US-A- 4 500 838**
**US-A- 5 731 703      US-A- 5 739 686**

## Description

Field of the Invention

This invention relates to a method and an apparatus for sensing a magnetic field and for detecting a magnetic flux density, each as a function of a measured Lorentz force.

Discussion of Related Art

Hall sensors have been used to sense magnetic fields. Hall effect transducers have been used with pole pieces and biasing magnets to increase sensitivity of the Hall sensors. When used with a magnet, a pole piece tends to channel a magnetic field and thus change flux densities in a magnetic circuit.

U.S. Patent 4,992,659 discloses a microscopy apparatus for measuring Lorentz force-induced deflection of a tip of a scanning tunneling microscope to image magnetic structures of a sample. Motion of the tip, which indicates the presence of a magnetic field, is optically detected. The magnetic field measurement and a tip position are received by a computer which provides an output signal to a device for graphically representing the magnetic field at different positions on a surface of the sample.

U.S. Patent 5,675,252 discloses a piezomagnetometer which uses a magnetoelectric composite structure, formed by alternating layers of piezoelectric and magnetostrictive material, to convert a fluctuating magnetic field directly to electric current. An ambient magnetic field strains magnetostrictive layers which stresses piezoelectric layers and drives a polarization current proportional to an amplitude of the magnetic field.

Document GB-A- 1 279 091 discloses the basic principles of magnetic field measurements using a magnetic field perpendicular to the direction of a current. circulating in a conductive strip thereby generating Lorentz forces inducing in turn mechanical.stress in the conductive strip.

It is apparent that there is a need for a method and apparatus that enables a microelectronic structure to sense a magnetic field and to measure a magnetic flux density. There is also a need for a method.and apparatus that produces a significantly higher output voltage, as compared to conventional methods and apparatuses, when exposed to the same magnetic field.

SUMMARY OF THE INVENTION

It is one object of this invention to provide a method and apparatus that uses a Lorentz force and a piezoelectric effect to detect the presence of a magnetic field and to measure a magnetic flux density of the magnetic field.

It is another object of this invention to provide a microelectronic structure that detects the presence of a magnetic field and measures a magnetic flux density of the magnetic field.

It is still another object of this invention to provide a method and apparatus that produces a significantly higher output voltage signal, as compared to known methods and apparatuses, when exposed to the same magnetic field.

The above and other objects of this invention are accomplished with a method for sensing a magnetic field wherein a direct-current voltage is applied across a first layer of a conductive material. A direct current flows in a first direction through the first layer. A second layer of piezoelectric material is either integrated with or is adhered to the first layer. The first layer and the second layer are positioned within or exposed to the magnetic field. A Lorentz force generated in a second direction, which is preferably but not necessarily generally perpendicular to the first direction, is generated causing the piezoelectric material to deflect. The presence of a magnetic field and/or a magnetic flux density of the magnetic field can be calculated as a function of the measured Lorentz force.

In one preferred embodiment according to this invention, the direct current is in a range of about 0.1 mA to about 10 mA, and preferably about 3 mA. Also in a preferred embodiment of this invention, a magnitude of the magnetic flux density is in a range of about 0.01 Tesla (100 Gauss) to about 0.1 Tesla (1,000 Gauss), preferably about 0.4 Tesla (400 Gauss).

The first layer of the conductive material and the second layer of the piezoelectric material can be moved within the magnetic field into a position where the magnitude of the Lorentz force is at a maximum value. In such position where the Lorentz force is at a maximum value, the two vectors representing the direct current and the magnetic field are at a right angle with respect to each other. The Lorentz force is generated in a direction which is preferably generally perpendicular to the directions of the vectors of the direct current and the magnetic field.

In one preferred embodiment according to this invention, an apparatus for sensing a magnetic field comprises the first layer of the conductive material integrated with, or applied to, the second layer of the piezoelectric material, such as by a sputtering technique or other suitable deposition technique. As the layer of piezoelectric material changes shape it produces a change in voltage. A sensor can then measure the Lorentz force generated by measuring the voltage. A computer is preferably used to receive the transducer output signal corresponding to the measured Lorentz force. The computer then calculates either the presence of a magnetic field or a magnitude of the magnetic flux density, as a function of the measured Lorentz force, using any suitable analog and/or digital circuit.

BRIEF DESCRIPTION OF THE DRAWINGS

The above-mentioned and other features and objects of this invention will be better understood from the following detailed description when taken in view of the drawings wherein:

Fig. 1 is a perspective schematic diagram of an apparatus according to one preferred embodiment of this invention; and
Fig. 2 is a schematic end view of a pole piece positioned near an apparatus, according to one preferred embodiment of this invention.

DESCRIPTION OF PREFERRED EMBODIMENTS

Apparatus 10, which is used to sense a presence of magnetic field 25 and/or to measure a magnetic flux density of magnetic field 25, comprises base 15, first layer 20 and second layer 22. The elements are preferably sized, shaped and otherwise designed so that apparatus 10 forms a microelectronic structure. Apparatus 10 and the corresponding method of this invention uses a combination of Lorentz force and piezoelectric effect to determine the presence of magnetic field 25 and/or to measure the magnetic flux density of magnetic field 25. In one preferred embodiment the magnetic flux density is in a selected range of about 0.01 Tesla (100 Gauss) to about 0.1 Tesla (1000 Gauss). The physical size, layout and/or materials of the different elements of apparatus 10 can be modified according to the strength of magnetic field 25 and/or the desired output voltage from apparatus 10.

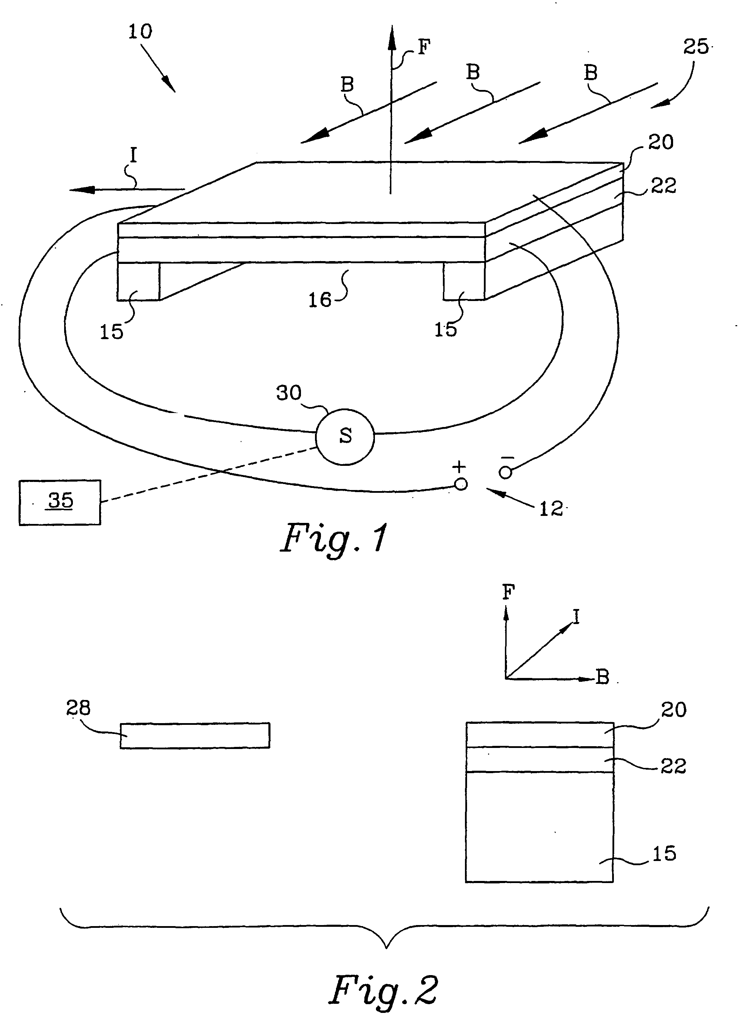

As shown in Fig. 1, second layer 22 spans two support surfaces of base 15, forming gap 16. Second layer 22 is preferably attached to, secured to or otherwise fixed to base 15 so that second layer 22 can deflect in a controlled or consistent fashion. Second layer 22 is constructed of a piezoelectric material, such as polyvinylidene fluoride, a copolymer of a polyvinylidene fluoride, or another suitable material that exhibits a change in voltage or electromotive force as a function of a change in shape. Piezoelectric materials suitable for use with this invention are known to those skilled in the art of microelectronic structures.

As shown in Fig. 1, second layer 22 spans or forms a bridge across the support surfaces of base 15. However, second layer 22 and base 15 can form any other suitable structure that accommodates or allows second layer 22 to deflect or change shape, such as when exposed to or introduced within magnetic field 25. Second layer 22 preferably but not necessarily has an overall strip shape, for example having a length in a range of about 1 mm to about 5 mm, a width in arrange of about 0.05 mm to about 0.15 mm and a thickness in a range of about 0.001 mm to about 0.010 mm. Base 15 can have any suitable shape or structure that provides support for second layer 22 and that allows at least a portion of second layer 22 to deflect or otherwise change shape. For example, rather than a spanning beam, second layer 22 may form a cantilever structure having only one end fixed to base 15, wherein second layer 22 extends over gap 16. Base 15 preferably forms gap 16 over which second layer 22 spans.

Base 15 is preferably constructed of a dielectric material, such as silicon, a composite containing silicon, or any other suitable material that has non-conductive properties, as known to those skilled in the art of microelectronic structures. Base 15 can be etched or produced with any other suitable manufacturing processes, also as known to those skilled in the art of microelectronic structures.

First layer 20 is preferably constructed of a conductive material, such as copper, gold. and/or aluminum. In one preferred embodiment according to this invention, first layer 20 is applied to second layer 22 using an electrical depositing method, such as a suitable sputtering technique as known to those skilled in the art of microelectronic structures. First layer 20 is positioned adjacent or abuts second layer 22 and thus preferably has similar dimensions to second layer 22.

Voltage source 12 is attached to or across first layer 20 so that a direct current passes through first layer 20, in a first direction. In one preferred embodiment according to this invention, the direct current is in a range of about 0.1 mA to about 100 mA, preferably about 3 mA. Voltage source 12 may comprise a battery or any other suitable direct-current voltage source known to those skilled in the art.

As shown in Fig. 1, sensor 30 is attached to or. connected to second layer 22 so that sensor 30 measures a voltage output from the piezoelectric second layer 22 corresponding to Lorentz force F generated in a second direction. In one preferred embodiment of this invention, the second direction of the Lorentz force is generally perpendicular to the first direction of the direct current passing through first layer 20. Sensor, 30 may also comprise an output for emitting an output signal which is proportional to a magnitude of the Lorentz force. It will be appreciated that Lorentz force F is maximal when the current and the magnetic field are perpendicular.

Apparatus 10 may also comprise computer means 35 for receiving the output signal and for calculating a presence of magnetic field 25 and/or a magnitude of and/or a direction of the magnetic flux density of magnetic field 25, preferably as a function of the measured Lorentz force. Computer means 35 may comprise any suitable hardware and/or software suitable for storing data and performing mathematic functions and/or algorithms. For example, an open-circuit output voltage (V0) of second layer 22 can be calculated according to the following known equation:

$$V_0 = -g_{31}^{(F/wt)(t)} = -g_{31}^{(F/w)}$$

where F is the magnitude of the Lorentz force, w is the width of second layer 22, t is the thickness of second layer 22, and g is the piezoelectric coefficient mode of second layer 22. According to the above equation, with second layer 22 shaped as a beam with w = 0.1 mm, $t$ = 0.006 mm, the length ($L$) = 3 mm, and with second layer 22 attached to base 15 at two locations and spanning gap 16, when exposed to magnetic field 25 having a magnetic flux density of 0.4 Tesla (400 Gauss), the measured Lorentz force F is about 36 x $10^{-6}$ Newton with a 0.8 mV piezoelectric output.

In one preferred embodiment according to this invention, the Lorentz force changes, such as by stretching, the shape of second layer 22. Because second layer 22 behaves as a strain gauge, a signal, such as the 0.8 mV signal, is generated. The 0.8 mV signal is much greater than signals generated from other conventional strain gauges that require further amplification to reach a magnitude similar to the magnitude achieved with apparatus 10 of this invention. For example, a conventional Hall sensor having a similar shape and dimensions would produce an output voltage of about $1.5 \times 10^{-6}$ mV when positioned within a magnetic field having the same magnetic flux density of 0.4 Tesla (400 Gauss).

The Lorentz force F is also expressed according to the following equation:

$$F = (I \times B)L$$

where $I$ is the direct current vector and $B$ is the magnetic field vector. The Lorentz force $F$ reaches a maximum value when the two vectors $I$ and $B$ are positioned at right angles with respect to each other. Thus in one preferred embodiment of this invention, apparatus 10 is positioned within magnetic field 25 so that the Lorentz force $F$ is in the second direction which is generally perpendicular to the first direction of the direct current vector I and to the third direction of the magnetic field vector B.

Referring to Fig. 2, in another preferred embodiment according to this invention, apparatus 10 further comprises pole piece 28 or a bias magnet. Pole piece 28 is used to alter magnetic field 25 of this invention in a fashion similar to how pole pieces are used in combination with conventional Hall sensors.

In one preferred embodiment of a method according to this invention, the direct-current voltage is applied across or to first layer 20 so that the direct current flows or passes through first layer 20, in the first direction. The direct-current voltage and/or the direct current can be measured and varied using meters, circuits and/ or voltage devices which are known to persons skilled in the art of microelectronic sensors.

Second layer 22 is adhered and positioned adjacent, or abuts, or is integrated with first layer 20. First layer 20 and second layer 22 are positioned within or exposed to magnetic field 25. In one preferred embodiment, apparatus 10 can be moved or positioned to generate the maximal Lorentz force F by placing the first direction of the direct current perpendicular to the third direction of magnetic field 25. It will be appreciated that F is always perpendicular to the current direction and the magnetic field, and that the strength of F decreases as the perpendicular vector of current to magnetic field decreases.

The generated Lorentz force F deflects second layer 22 which outputs a voltage which is measured as an output signal and is preferably transmitted to computer means 35. The measured Lorentz force F can then be used to detect the presence of magnetic field 25 and/ or to measure the magnitude of the magnetic flux density of magnetic field 25.

While in the foregoing specification this invention has been described in relation to certain preferred embodiments thereof, and many details have been set forth for purpose of illustration it will be apparent to those skilled in the art that the invention is susceptible to additional embodiments and that certain of the details described herein can be varied considerably without departing from the scope of the invention, as defined by the set of appended claims.

**Claims**

1. A method for sensing a magnetic field (25), comprising:

   (a) applying a direct-current voltage across a first layer (20) of a conductive material wherein a direct current flows in a first direction;
   (b) arranging a second layer (22) of a piezoelectric material to be integrated with, adhered to or to abut the first layer (20) and within the magnetic field(25);
   (c) attaching the second layer (22) to a base (15);
   (d) generating a Lorentz force (F) in a second direction generally perpendicular to the first direction to deflect the piezoelectric layer (22);
   (e) detecting a voltage output of the piezoelectric layer (22); and
   (f) calculating a magnetic flux density of the magnetic field (25) as a function of the voltage output of the piezoelectric layer (22) as caused by the Lorentz force (F).

2. A method for sensing a magnetic field (25), as defined in claim 1 wherein, the base is manufactured by
   providing a substrate (15) and
   etching the substrate (15) to provide a gap (16), wherein
   the first layer (20) and the second layer (22) extend at least partially over the gap.

**3.** A method according to claim 1 wherein the direct current is in a range of about 0.1 mA to about 10mA.

**4.** A method according to claim 1 wherein the magnetic field (25) is oriented in a third direction generally perpendicular to the first direction.

**5.** Use of a method according to claim 1 wherein the magnitude of the magnetic field (25) to be sensed has a magnetic flux density in the range of about 0.01 Tesla (100 Gauss) to about 0.1 Tesla (1000 Gauss).

**6.** A method according to claim 1 wherein the second layer (22) of the piezoelectric material acts in a piezoelectric coefficient $g_{31}$ mode, wherein said $g_{31}$ mode is defined by the equation: $v_o = -g_{31}^{(F/wt)(t)} = -g_{31}^{(F/W)}$ wherein $V_o$ is open-circuit output voltage of the second layer (22), F is the magnitude of the Lorentz force, W is the width of the second layer (22) and t is the thickness of the second layer (22).

**7.** A method according to claim 1 wherein the conductive layer (20) and the piezoelectric layer (22) are oriented with respect to the magnetic field (25) in a position where a magnitude of the Lorentz force (F) is at a maximum value.

**8.** A method according to claim 1 further comprising prebiasing the Lorentz force (F) by positioning a pole piece (28) near the first layer (20) and the second layer (22).

**9.** An apparatus for sensing a magnetic field (25), comprising:

> a first layer (20) of a conductive material, a voltage source (12) attached to and directing a current in a first direction through the first layer (20), **characterised in that** the apparatus further comprises:

>> a second layer (22) of a piezoelectric material integrated with, adhered to or abutting the first layer (20), means for measuring a voltage output of the piezoelectric material; and
>> a base structure (15) forming a gap (16), the second layer (22) attached to the base, at least a portion of the second layer (22) spanning at least a portion of the gap (16).

**10.** An apparatus according to claim 9 wherein the measuring means emits an output signal corresponding to a Lorentz force (F) generated.

**11.** An apparatus according to claim 10 further comprising:

> computer means (35) for receiving the output signal and calculating a magnetic flux density of a magnetic field (25) as a function of the Lorentz force (F).

**12.** An apparatus according to claim 9 wherein the conductive material is electrically deposited on a face of the second layer (22).

**13.** An apparatus according to claim 9 wherein the conductive material is at least one of a copper material, a gold material and an aluminium material.

**14.** An apparatus according to claim 9 wherein the piezoelectric material is at least one of a polyvinylidene fluoride and a copolymer of polyvinylidene fluoride.

**15.** An apparatus according to claim 9 wherein the dielectric material is of a silicon material.

**16.** An apparatus according to claim 9 wherein the first layer (20) is formed as a first strip and the second layer (22) is formed as a second strip.

**17.** An apparatus according to claim 9 wherein the first layer (20) is formed as a first strip having a length in a first range of about 1mm to about 5mm, a width in a second range of about 0.05mm to about 0.15mm, and a thickness in a third range of about 0.001mm to about 0.010mm.

**18.** An apparatus according to claim 9 further comprising at least one of a pole piece (28) and a bias magnet positioned near the first layer (20) and the second layer (22).

**19.** An apparatus according to claim 18 wherein the at least one of the pole piece (28) and the bias.magnet are fixed with respect to the first layer (20) and the second layer (22).

**Patentansprüche**

**1.** Verfahren zum Nachweisen eines Magnetfelds (25), umfassend:

> (a) Anlegen einer Gleichstromspannung über eine erste Schicht (20) eines leitenden Materials, wobei ein Gleichstrom in eine erste Richtung fließt;
> (b) Anordnen einer zweiten Schicht (22) eines piezoelektrischen Materials integriert in, haftend auf oder angrenzend an die erste Schicht (20) und innerhalb des Magnetfelds (25);
> (c) Befestigen der zweiten Schicht (22) auf einer Auflage (15);
> (d) Erzeugen einer Lorentzkraft (F) in eine zweite Richtung, die im Allgemeinen senkrecht auf der ersten Richtung steht, um die piezoelektrische Schicht (22) auszulenken;

(e) Nachweisen einer von der piezoelektrischen Schicht (22) gelieferten Spannung; und

(f) Berechnen einer magnetischen Flussdichte des Magnetfelds (25) als Funktion der von der piezoelektrischen Schicht (22) gelieferten, durch die Lorentzkraft (F) hervorgerufenen Spannung.

2. Verfahren zum Nachweisen eines Magnetfelds (25) nach Anspruch 1, wobei die Auflage hergestellt wird durch

Bereitstellen eines Substrats (15) und

Ätzen des Substrats (15), um einen Zwischenraum (16) zu schaffen, wobei

die erste Schicht (20) und die zweite Schicht (22) sich mindestens teilweise über den Zwischenraum erstrecken.

3. Verfahren nach Anspruch 1, wobei der Gleichstrom in einem Bereich von ca. 0,1 mA bis ca. 10 mA liegt.

4. Verfahren nach Anspruch 1, wobei das Magnetfeld (25) an einer dritten Richtung ausgerichtet ist, die im Allgemeinen senkrecht auf der ersten Richtung steht.

5. Anwenden des Verfahrens nach Anspruch 1, wobei die Größe des nachzuweisenden Magnetfelds (25) durch eine magnetische Flussdichte im Bereich von ca. 0,01 Tesla (100 Gauß) bis ca. 0,1 Tesla (1000 Gauß) gegeben ist.

6. Verfahren nach Anspruch 1, wobei die zweite Schicht (22) des piezoelektrischen Materials in einer $g_{31}$-Piezokoeffizenten-Mode arbeitet, wobei die $g_{31}$-Mode durch die Gleichung $V_0 = - g_{31}{}^{(F/wt)(t)} = - g_{31}{}^{(F/W)}$ bestimmt ist, wobei $V_0$ die Leerlaufausgangsspannung der zweiten Schicht (22), F den Betrag der Lorentzkraft, W die Breite der zweiten Schicht (22) und t die Dicke der zweiten Schicht (22) bezeichnen.

7. Verfahren nach Anspruch 1, wobei die leitende Schicht (20) und die piezoelektrische Schicht (22) derart gegen das Magnetfeld (25) ausgerichtet sind, dass der Betrag der Lorentzkraft (F) maximal wird.

8. Verfahren nach Anspruch 1, weiterhin umfassend das Vorverstärken der Lorentzkraft (F) dadurch, dass ein Polschuh (28) nahe der ersten Schicht (20) und der zweiten Schicht (22) angeordnet ist.

9. Vorrichtung zum Nachweisen eines Magnetfelds (25), umfassend:

eine erste Schicht (20) aus einem leitenden Material, eine Spannungsquelle (12), die an der ersten Schicht (20) angebracht ist und einen Strom in einer ersten Richtung durch selbige leitet, **dadurch gekennzeichnet, dass** die Vorrichtung außerdem Folgendes umfasst:

eine zweite Schicht (22) aus einem piezoelektrischen Material, die in die erste Schicht (20) integriert ist, auf dieser haftet oder an diese angrenzt, Mittel zum Messen einer von dem piezoelektrischen Material gelieferten Spannung; und

eine Auflagestruktur (15), die einen Zwischenraum (16) bildet, wobei die zweite Schicht (22) auf der Auflage befestigt ist und mindestens ein Abschnitt der zweiten Schicht (22) mindestens einen Abschnitt des Zwischenraums (16) überspannt.

10. Vorrichtung nach Anspruch 9, wobei das Messmittel ein Ausgangssignal ausgibt, das der erzeugten Lorentzkraft (F) entspricht.

11. Vorrichtung nach Anspruch 10, weiterhin umfassend: Computermittel (35) zum Empfangen des Ausgangssignals und zum Berechnen einer magnetischen Flussdichte eines magnetischen Felds (25) als Funktion der Lorentzkraft (F).

12. Vorrichtung nach Anspruch 9, wobei das leitende Material elektrisch auf eine Oberfläche der zweiten Schicht (22) aufgebracht ist.

13. Vorrichtung nach Anspruch 9, wobei es sich bei dem leitenden Material um ein Kupfermaterial, ein Goldmaterial und/oder ein Aluminiummaterial handelt.

14. Vorrichtung nach Anspruch 9, wobei es sich bei dem piezoelektrischen Material um ein Polyvinylidenfluorid und/oder um ein Copolymer von Polyvinylidenfluorid handelt.

15. Vorrichtung nach Anspruch 9, wobei das dielektrische Material aus einem Siliciummaterial besteht.

16. Vorrichtung nach Anspruch 9, wobei die erste Schicht (20) als erster Streifen und die zweite Schicht (22) als zweiter Streifen geformt sind.

17. Vorrichtung nach Anspruch 9, wobei die erste Schicht (20) als erster Streifen geformt ist, der eine Länge in einem ersten Bereich von ca. 1 mm bis ca. 5 mm, eine Breite in einem zweiten Bereich von ca. 0,05 mm bis ca. 0,15 mm und eine Dicke in einem dritten Bereich von ca. 0,001 mm bis ca. 0,010 mm aufweist.

**18.** Vorrichtung nach Anspruch 9, weiterhin umfassend einen Polschuh (28) und/oder einen Magneten zur Vormagnetisierung, der/die nahe der ersten Schicht (20) und der zweiten Schicht (22) angeordnet ist/ sind.

**19.** Vorrichtung nach Anspruch 18, wobei der Polschuh (28) und/oder der Magnet zur Vormagnetisierung bezüglich der ersten Schicht (20) und der zweiten Schicht (22) fixiert ist/sind.

**Revendications**

**1.** Méthode de détection d'un champ magnétique (25) comprenant :

(a) L'application d'une tension continue aux bornes d'une première couche (20) d'un matériau conducteur dans laquelle un courant continu circule dans une première direction ;
(b) L'arrangement d'une deuxième couche (22) d'un matériau piézoélectrique à intégrer avec, à faire adhérer sur ou à joindre à la première couche (20) et à l'intérieur du champ magnétique (25) ;
(c) La fixation de la deuxième couche (22) à une base (15) ;
(d) La génération d'une force de Lorentz (F) dans une deuxième direction généralement perpendiculaire à la première direction afin de dévier la couche piézoélectrique (22) ;
(e) La détection d'une tension de sortie de la couche piézoélectrique (22) ; et
(f) Le calcul d'une densité de flux magnétique du champ magnétique (25) en fonction de la tension de sortie de la couche piézoélectrique (22) telle qu'elle est produite par la force de Lorentz (F').

**2.** Méthode de détection d'un champ magnétique (25) selon la revendication 1 dans laquelle la base est fabriquée en fournissant un substrat (15) et en gravant le substrat (15) de manière à produire une ouverture (16) dans laquelle la première couche (20) et la deuxième couche (22) s'étendent au moins partiellement sur l'ouverture.

**3.** Méthode selon la revendication 1, dans laquelle le courant continu est compris entre environ 0,1 mA et environ 10 mA.

**4.** Méthode selon la revendication 1, dans laquelle le champ magnétique (25) est orienté dans une troisième direction généralement perpendiculaire à la première direction.

**5.** Utilisation d'une méthode selon la revendication 1, dans laquelle l'amplitude du champ magnétique (25) à détecter possède une densité de flux magnétique comprise entre environ 0,01 Tesla (100 Gauss) et environ 0,1 Tesla (1000 Gauss).

**6.** Méthode selon la revendication 1, dans laquelle la deuxième couche (22) de matériau piézoélectrique agit dans un mode de coefficient piézoélectrique $g_{31}$, dans laquelle ledit mode $g_{31}$ est défini par l'équation : $V_o = -g_{31}^{(F/wt)(t)} = -g_{31}^{(F/W)}$ où $V_o$ est la tension de sortie sur circuit ouvert de la deuxième couche (22), F est l'amplitude de la force de Lorentz, W est la largeur de la deuxième couche (22) et t est l'épaisseur de la deuxième couche (22).

**7.** Méthode selon la revendication 1, dans laquelle la couche conductrice (20) et la couche piézoélectrique (22) sont orientées par rapport au champ magnétique (25) dans une position où une amplitude de la force de Lorentz (F) est à sa valeur maximale.

**8.** Méthode selon la revendication 1, comprenant en plus la pré-polarisation de la force de Lorentz (F) en positionnant un élément polaire (28) à proximité de la première couche (20) et de la deuxième couche (22).

**9.** Appareil de détection d'un champ magnétique (25) comprenant
une première couche (20) d'un matériau conducteur, une source de tension (12) raccordée à la première couche (20) et dirigeant un courant dans une première direction à travers celle-ci, **caractérisé en ce que** l'appareil comprend en plus :
une deuxième couche (22) d'un matériau piézoélectrique intégrée avec, adhérée sur ou jointe à la première couche (20), des moyens pour mesurer une tension de sortie du matériau piézoélectrique ; et
une structure de base (15) formant une ouverture (16), la deuxième couche (22) attachée à la base, au moins une portion de la deuxième couche (22) recouvrant au moins une portion de l'ouverture (16).

**10.** Appareil selon la revendication 9, dans lequel les moyens de mesure émettent un signal de sortie correspondant à une force de Lorentz (F) générée.

**11.** Appareil selon la revendication 10, comprenant en plus des moyens informatiques (35) pour recevoir le signal de sortie et calculer une densité de flux magnétique d'un champ magnétique (25) en fonction de la force de Lorentz (F).

**12.** Appareil selon la revendication 9, dans lequel le matériau conducteur est appliqué par électrodéposition sur une face de la deuxième couche (22).

**13.** Appareil selon la revendication 9, dans lequel le matériau conducteur est au moins l'un des matériaux suivant : cuivre, or et aluminium.

**14.** Appareil selon la revendication 9, dans lequel le matériau piézoélectrique est au moins l'un des suivants : fluorure de polyvinylidène et copolymère de fluorure de polyvinylidène.

**15.** Appareil selon la revendication 9, dans lequel le matériau diélectrique est du silicium.

**16.** Appareil selon la revendication 9, dans lequel la première couche (20) est formée sous la forme d'une première bande et la deuxième couche (22) est formée sous la forme d'une deuxième bande.

**17.** Appareil selon la revendication 9, dans lequel la première couche (20) est formée sous la forme d'une première bande dont la longueur est comprise dans une première fourchette entre environ 1 mm et environ 5 mm, la largeur dans une deuxième fourchette entre environ 0,05 mm et environ 0,15 mm et l'épaisseur dans une troisième fourchette entre environ 0,001 mm et environ 0,010 mm.

**18.** Appareil selon la revendication 9, comprenant en plus au moins un élément parmi un élément polaire (28) et un aimant de polarisation positionnés à proximité de la première couche (20) et de la deuxième couche (22).

**19.** Appareil selon la revendication 18, dans lequel l'au moins un élément parmi l'élément polaire (28) et l'aimant de polarisation sont fixés par rapport à la première couche (20) et à la deuxième couche (22).

*Fig.1*

*Fig.2*